Europäisches Patentamt

European Patent Office

Office européen des brevets

(11) Publication number: **0 213 299**
**A2**

(12) **EUROPEAN PATENT APPLICATION**

(21) Application number: **86108350.9**

(22) Date of filing: **19.06.86**

(51) Int. Cl.4: **H01L 21/76**

The title of the invention has been amended (Guidelines for Examination in the EPO, A-III, 7.3).

(30) Priority: **21.06.85 JP 133940/85**

(43) Date of publication of application:
**11.03.87 Bulletin 87/11**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Kitahara, Koichi**
**c/o Patent Division K.K. Toshiba 1-1**
**Shibaura 1-chome Minato-ku Tokyo 105(JP)**

(74) Representative: **Eitle, Werner, Dipl.-Ing. et al**
**Hoffmann, Eitle & Partner Patentanwälte**
**Arabellastrasse 4**
**D-8000 München 81(DE)**

(54) **Method for manufacturing a semiconductor device having an element isolation area.**

(57) A method for manufacturing a semiconductor device having an improved dielectric isolation is disclosed which comprises the steps of forming recesses in one surface portion of a first semiconductor substrate (1), forming an insulating film (3) on the surface of the first semiconductor substrate (1) including the inner surface of the recess, depositing a solid material (4) on the insulating film (3) with the recess filled with the solid material (4) so as to obtain a flat surface, mirror-polishing the flat surface, mirror-polishing one surface of a second semiconductor substrate (5), bonding the first and second semiconductor substrates (1, 5) with their mirror-polished surfaces contacting each other in a face-to-face relation, grinding the reverse surface of the first semiconductor substrate (1) thus bonded to partly expose the insulating film (3), and forming a functional element in that remaining portion (6) of the first semiconductor substrate at an area isolated by the insulating film.

F I G. 3

F I G. 4

## Method for manufacturing a semiconductor device

This invention relates to a method for manufacturing a semiconductor device having an element isolation area.

Conventionally, a diode, collector junction of a bipolar transistor etc., and a drain junction of a double diffusion type MOSFET etc. are operated with their pn junction reverse-biased. In order to decrease the series resistance induced, use is made of a two-layer semiconductor structure in which an n-type semiconductor layer in formed on, for example, an n-type semiconductor substrate. Usually, an impurity is diffused into the n-type semiconductor layer to form a pn junction and thus forming a semiconductor element. At this time, an adequate spacing is usually provided between the pn junction and the n-type semiconductor substrate, thereby preventing a "reach-through", a phenomenon whereby a depletion layer occurring upon the operation of the semiconductor element reaches into the n-type semiconductor substrate.

A pn junction isolation and dielectric isolation technique are known as a method for electrically isolating a plurality of elements on a common semiconductor substrate.

In the pn junction isolation method, an n-type silicon epitaxial is formed on a p-type silicon substrate and a p-type impurity is selectively diffused through the surface of a resulting structure into the p-type silicon substrate to provide a pn junction. Whereby an area surrounded by the pn junction is electrically isolated upon the application of a reverse bias to the pn junction.

In the dielectric isolation technique, an n-type silicon substrate is selectively etched to provide a plurality of recesses. The resultant structure is thermally oxidized to form an oxide film over a whole surface, including the inner surface of these recesses, and a polycrystalline silicon layer is deposited on the oxide film. Finally, the resultant structure is ground on the reverse surface side of the substrate to each recess, whereby an island area surrounded by the oxide film and polycrystalline silicon is electrically isolated.

In the pn junction isolation technique, a leakage current through the pn junction exerts a bad influence over a functional element formed in an island area. In the dielectric isolation technique, on the other hand, a breakdown voltage of the isolating region is high, and it is not necessary to apply a bias voltage for isolation. In order to increase the mechanical strength of the semiconductor substrate, however, the polycrystalline silicon layer has to be thickened, presenting an economy problem. For the polycrystalline silicon layer of a greater thickness, a larger stress is produced in the underlying semiconductor substrate, thus exerting a bad influence over a semiconductor element in the island area.

It is accordingly the object of this invention to provide a method for manufacturing a semiconductor device through the utilization of a novel dielectric isolation technique free from any drawbacks of a conventional dielectric isolation technique.

The method of this invention is based on the observation that, when two semiconductor substrates are bonded to each other with their mirror-polished surfaces contacting each other, a composite semiconductor substrate with a strong bond can be obtained.

That is, a method for manufacturing a semiconductor device is provided according to this invention, which comprises the steps of forming recesses in one surface of a first semiconductor substrate, forming an insulating film on the surface of the first semiconductor substrate including the inner surface of the recess, depositing a solid material on the insulating film with the recess filled with the solid material so as to obtain a flat surface, mirror-polishing the flat surface of the resultant structure, mirror-polishing one surface of a second semiconductor substrate, bonding the first and second semiconductor substrates with their mirror-polished surface contacting each other in a face-to-face relation, grinding a reverse surface of the first semiconductor substrate to partially expose the insulating film, and forming a functional element in that grinded surface portion of the resultant semiconductor structure which is isolated by the insulating film.

According to this invention, the first and second semiconductor substrates can be properly bonded to each other, with their mirror-polished surfaces contacting each other in the face-to-face relation, irrespective of a difference in their conductivity type and in the level of impurity concentration. At this time, an interfacial layer somewhat different in crystalline structure from these substrates is formed at a boundary of both the substrates to provide an integral structure, i.e., a composite semiconductor substrate of a mechanical strength which can be treated as a single substrate. In this case, it is considered that a grain boundary is formed at the interfacial layer and does not function as a mechanical or a thermal barrier.

It is a well-known fact that, if a semiconductor layer different in the conductivity type and in the impurity concentration from a substrate is deposited on that substrate by virtue of a vapor growth method, an interfacial portion is displaced in accordance with the level of a thermal load applied to the substrate at a later stage. In this connection, it may be considered that the interfacial layer formed according to this invention is somewhat displaced due to a thermal load applied to the substrate.

It has been confirmed that a functional element obtained by forming a pn junction, etc. in a composite substrate finds a practical application.

According to this invention, a polycrystalline silicon can be used as a solid material for planarizing the first semiconductor substrate.

According to this invention, a perfect dielectric isolation can be obtained without causing a deformation or crystal defect in the substrate, thus improving the integration density of a semiconductor element.

This invention can be more fully understood from the following detailed description when taken in conjunction with the accompanying drawings, in which:

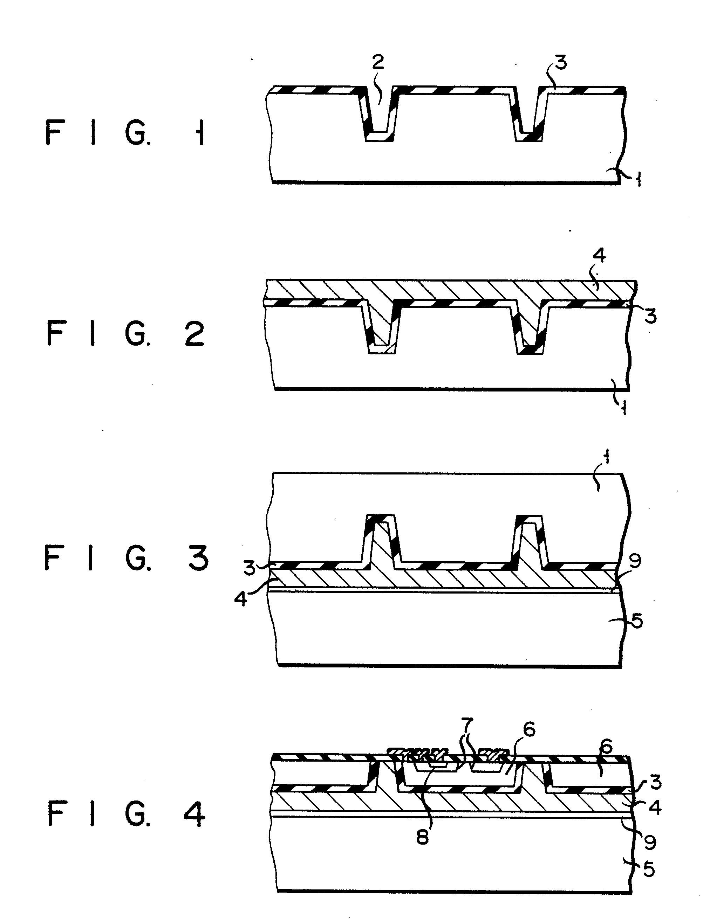

Figs. 1 to 4 are cross-sectional views showing the steps of manufacturing a semiconductor device according to an embodiment of this invention.

The preferred embodiment of this invention will be explained below with reference to Figs. 1 to 4, starting with a bonding step.

## Bonding Step

First, the opposite surfaces of two semiconductor substrates are mirror-polished to provide a surface roughness of below 500 Å. Depending upon their surface state, the surface of the resultant semiconductor substrate is treated with a mixture of $H_2O$ and $H_2SO_4$, then HF and finally dilute HF to perform a degreasing step and stain film removing step.

Then the mirror-polished surfaces of the semiconductor substrates are washed with clean water for a few minutes, and dried below room temperature, for example, spin-dried by means of a spinner. At this time, it is necessary to remove excess water with an adsorbed moisture left in and on the mirror-polished surfaces of the semiconductor substrates. That is, it is necessary to avoid a heat-drying operation at above 100°C at which the adsorbed moisture is almost removed.

Then the semiconductor substrates so treated are placed in a clean atmosphere of class 1 or more and bonded to each other with their mirror-polished surfaces aligned in a face-to-face relation, providing a composite semiconductor substrate. The composite semiconductor substrate may be heat-treated at a temperature of 200°C or higher, preferably, 1000-1200°C to increase its bonding strength.

## Example

First semiconductor substrate 1 of a proper resistivity is prepared, noting that since a semiconductor element is formed in subtrate 1 the aforementioned resistivity is properly selected in accordance with the element characteristic. Where an elements with a breakdown voltage of, for example, 500 V is to be obtained, use may be made of an n-type semiconductor substrate having a resistivity of about 50 Ω-cm.

Recesses 2 of 20 to 30 μm in depth are formed in the surface portion of substrate 1 at an interval of 4 to 5 mm by virtue of a reactive ion etching. Then, the surface of substrate 1 is oxidized by an ordinary thermal oxidation to form oxide film 3 of about 2 μm in thickness as shown in Fig. 1. Polycrystalline silicon layer 4 is formed over the entire surface of substrate 1 to obtain a flat surface. Where, in this case, polycrystalline silicon layer 4 is 4 to 5 μm in thickness, then it is possible to obtain an almost flat surface.

Second semiconductor substrate 5 of 450 μm in thickness is prepared which serves merely as a support. In this case, since a semiconductor element, which is formed in substrate 1, is of a so-called lateral type, substrate 5 may be of any proper conductivity type with any proper impurity concentration level.

The surfaces of the first and second semiconductor substrates thus obtained are mirror-polished to provide a surface roughness of below 500 Å. These first and second semiconductors are bonded to each other with their mirror-polished surfaces aligned in a face-to-face contact relation, thus obtaining a composite semiconductor substrate as shown in Fig. 3. In this case, it may be considered that an interfacial layer is formed between the surfaces of the first and second substrates. Then, the outer surface of the composite semiconductor substrate, which is located on the side of first semiconductor substrate 1, is so ground as to reach oxide film 3 or polycrystalline silicon film 4 at the bottom of recesses 2. As a result, island area 6 is isolated from another island area, and from the second semiconductor substrate, by oxide film 3 and polycrystalline silicon layer 4 as shown in Fig. 4.

A p-type impurity is diffused into island area to form pn junctions 7. An n-type impurity is diffused into one of formed p-type impurity regions to provide pn junction 8. Electrodes are formed on the respective impurity regions. Similarly, a desired semiconductor element is formed in the other island areas, completing an integrated circuit.

In the method of this invention, the polycrystalline silicon layer for isolation is made thinner and thus the substrate on which the polycrystalline silicon layer is produced is less deformed, improving the characteristic of the element in the respective island area. Where the polycrystalline silicon layer is to be formed by a vapor growth method on a 450 μm-thick semiconductor substrate, if the thickness of a polycrystalline silicon layer becomes greater than 80 μm, the substrate is greatly warped, failing to properly deposit the polycrystalline silicon layer on such semiconductor substrate. According to this invention, the thickness of the polycrystalline silicon layer needs only to be enough great as to fill the recess in the semiconductor substrate, offering no "warp" problem. Furthermore, it is only required that the substrate to be bonded to the mirror-polished surface of the polycrystalline silicon layer have a necessary mechanical strength.

## Claims

1. A method for manufacturing a semiconductor device, comprising:

forming recesses (2) in one surface portion of a first semiconductor substrate (1);

forming an insulating film (3) on the surface of the first semiconductor substrate including an inner surface of the recess (2);

depositing a solid material (4) on the insulating film to fill the recess (2) with that material (4) so as to obtain a flat surface;

mirror-polishing the flat surface of the resultant structure;

mirror-polishing one surface of a second semiconductor substrate (5);

bonding the first and second semiconductor substrates (1, 5) with their mirror-polished surfaces contacting each other in a face-to-face relation;

grinding a reverse surface of the first semiconductor substrate (1) to partly expose the insulating film (3); and

forming a functional element in that remaining portion of the first semiconductor substrate which is isolated by the insulating film.

2. A method according to claim 1, characterized in that said insulating film (3) is a silicon oxide film and said solid material (4) is a polycrystalline silicon.

3. A method according to claim 1, characterized in that said mirror-polishing step is performed to obtain a surface roughness of below 500 Å.

4. A method according to claim 1, further comprising heating said bonded first and second semiconductor substrates (1, 5).

5. A method according to claim 4, characterized in that said heating step is performed at a temperature of above 200°C.

6. A method according to claim 5, characterized in that said heating step is performed at a temperature of 1000 to 1200°C.

F I G. 1

F I G. 2

F I G. 3

F I G. 4